Europäisches Patentamt

European Patent Office

Office européen des brevets

(19)

(11) Numéro de publication: **0 211 700**

**A1**

(12) **DEMANDE DE BREVET EUROPEEN**

(21) Numéro de dépôt: 86401260.4

(22) Date de dépôt: 10.06.86

(51) Int. Cl.⁴: **H03K 17/687** , H03K 3/356

(30) Priorité: 11.06.85 FR 8508806

(43) Date de publication de la demande:
25.02.87 Bulletin 87/09

(84) Etats contractants désignés:
BE DE GB IT NL

(71) Demandeur: **COMPAGNIE D'INFORMATIQUE MILITAIRE SPATIALE ET AERONAUTIQUE**
**25, rue de Courcelles**
**F-75008 Paris(FR)**

(72) Inventeur: **Arnould, Guy**
**THOMSON-CSF SCPI 19, avenue de Messine**
**F-75008 Paris(FR)**
Inventeur: **Bui, Liem**
**THOMSON-CSF SCPI 19, avenue de Messine**
**F-75008 Paris(FR)**

(74) Mandataire: **El Manouni, Josiane et al**
**THOMSON-CSF SCPI 19, avenue de Messine**
**F-75008 Paris(FR)**

(54) **Dispositif miniaturisé de transmission d'informations binaires par transformateur d'impulsions avec reconstitution de la composante continue.**

(57) Ce dispositif comporte, disposés en aval d'un transformateur d'impulsions (T) des moyens (A, A', B, B') de détection d'impulsion incidente (E), des moyens pour mémoriser l'information contenue dans cette impulsion incidente, et des moyens (C) pour stocker de l'énergie préalablement à la réception de cette impulsion, et pour la restituer à la détection de cette impulsion, le signal de sortie (S) étant obtenu par superposition, à cette énergie restituée, de l'information mémorisée.

Application notamment à la commande impulsionnelle de transistors MOS de puissance.

Fig.1

EP 0 211 700 A1

# DISPOSITIF MINIATURISE DE TRANSMISSION D'INFORMATIONS BINAIRES PAR TRANSFORMATEUR D'IMPULSIONS AVEC RECONSTITUTION DE LA COMPOSANTE CONTINUE

La présente invention concerne la transmission d'informations binaires par transformateur d'impulsions.

L'avantage principal de la transmission d'informations binaires par transformateur d'impulsions et de transmettre aussi sur la ligne isolée l'énergie support de cette information. Par contre ce type de transmission n'est pas compatible avec des impulsions de grande durée, si ce n'est au prix d'un accroissement de la taille du transformateur, et de façon générale avec un signal présentant une composante continue. L'utilisation de coupleur optique, si elle est parfaitement compatible avec la transmission de la composante continue, ne permet cependant pas de transmettre l'énergie qui doit être fournie par une source externe au potentiel de la ligne isolée.

La présente invention a pour objet un dispositif miniaturisé qui met en oeuvre un transformateur d'impulsions et qui permet de transmettre aussi bien des impulsions de largeur et de rapport cyclique variable que des états logiques, sans nécessiter de source d'énergie externe.

Suivant l'invention, le dispositif miniaturisé de transmission d'informations binaires par transformateur d'impulsions avec reconstitution de la composante continue comporte, disposés en aval du transformateur d'impulsions :

-des premiers moyens de détection d'impulsion incidente ;

-des deuxièmes moyens pour mémoriser l'information contenue dans cette impulsion incidente ;

-des troisièmes moyens pour stocker de l'énergie, préalablement à la réception de cette impulsion et pour la restituer à la détection de cette impulsion, le signal de sortie étant obtenu par superposition à cette énergie restituée de l'information mémorisée.

Les objets et caractéristiques de la présente invention apparaîtront plus clairement à la lecture de la description suivante d'un exemple de réalisation, faite en relation avec les dessins ci-annexés dans lesquels ;

-la figure 1 est un schéma d'un dispositif de reconstitution d'impulsions suivant l'invention ;

-la figure 2 est un schéma illustrant l'établissement des différents chemins électriques dans le dispositif suivant l'invention pour une impulsion positive ;

-la figure 3 est un schéma illustrant l'établissement des différents chemins électriques dans le dispositif suivant l'invention pour une impulsion négative ;

-la figure 4 est un schéma détaillé de réalisation du dispositif suivant l'invention ;

-la figure 5 est un diagramme des temps illustrant la forme des impulsions en entrée et en sortie du dispositif suivant l'invention ;

-la figure 6 est un schéma montrant l'application du dispositif suivant l'invention à la commande d'un transistor MOS de puissance.

-la figure 7 est une application du dispositif dans la transmission multivoie isolées, pilotée par microprocesseur.

Sur ces différentes figures, on a représenté les mêmes éléments avec les mêmes références.

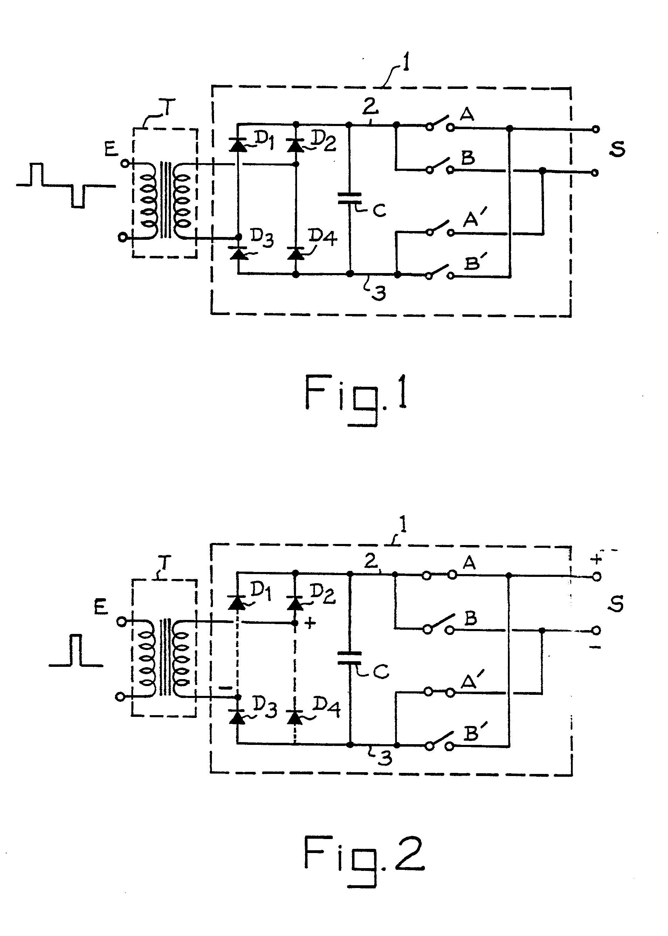

Le dispositif de reconstitution d'impulsions 1 représenté sur la figure 1 est connecté aux bornes de l'enroulement secondaire d'un transformateur T dont l'enroulement primaire reçoit un signal d'entrée E en impulsions.

Ce dispositif comporte essentiellement deux fils de ligne 2 et 3 sur chacun desquels est disposé un commutateur A,A' et entre lesquels est disposé un élément passif de stockage d'énergie, en l'occurrence un condensateur C.

En pratique, pour tenir compte du fait que les impulsions d'entrée peuvent être positives ou négatives, un pont de redressement à diodes $D_1$, $D_2$, $D_3$, $D_4$ est disposé en entrée du dispositif 1 pour charger le condensateur C, et deux commutateurs supplémentaires B, B' sont rajoutés, chaque couple de commutateurs (respectivement A et A', B et B') étant passant pour un type d'impulsion d'entrée donné.

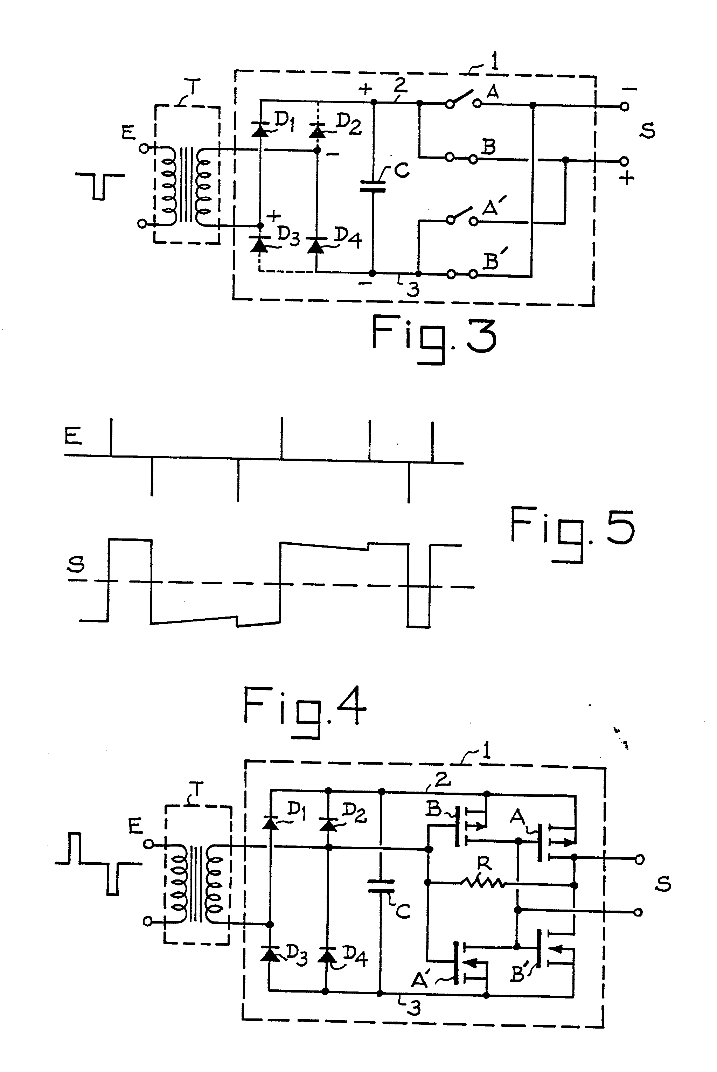

Les différents chemins électriques qui s'établissent dans le dispositif 1 suivant le type d'impulsion d'entrée, positive ou négative, ont été représentés sur les figures 2 et 3 de la façon suivante : on a représenté en traits pointillés les branches du pont de redressement à diodes non parcourues par un courant, et on a représenté l'état (ouvert ou fermé) des commutateurs A, A', B et B' dans chacun des cas.

Sur la figure 4 on a représenté un mode de réalisation des commutateurs A, A', B et B'. Ce mode de réalisation utilise des transistors du type MOS. Les deux transistors matérialisant les commutateurs B et A' ont leur grille reliée à l'une des bornes de l'enroulement secondaire, leur source reliée respectivement à l'un des fils de ligne 2 et 3 du dispositif 1 et leur drain respectivement relié à la grille de l'un des deux transistors matérialisant les commutateurs A et B', ces derniers ayant leur source reliée respectivement à l'un des fils de ligne 2 et 3 du dispositif 1. Le drain des transistors A et B' constitue l'une des sorties du dispositif 1, le drain des transistors B et A' l'autre sortie. Une résistance R est par ailleurs connectée entre la grille des transistors B et A' d'une part, et le drain des transistors A et B' d'autre part.

Le fonctionnement du dispositif représenté sur les figures 1, 2, 3 et 4 est maintenant expliqué en relation avec la figure 5.

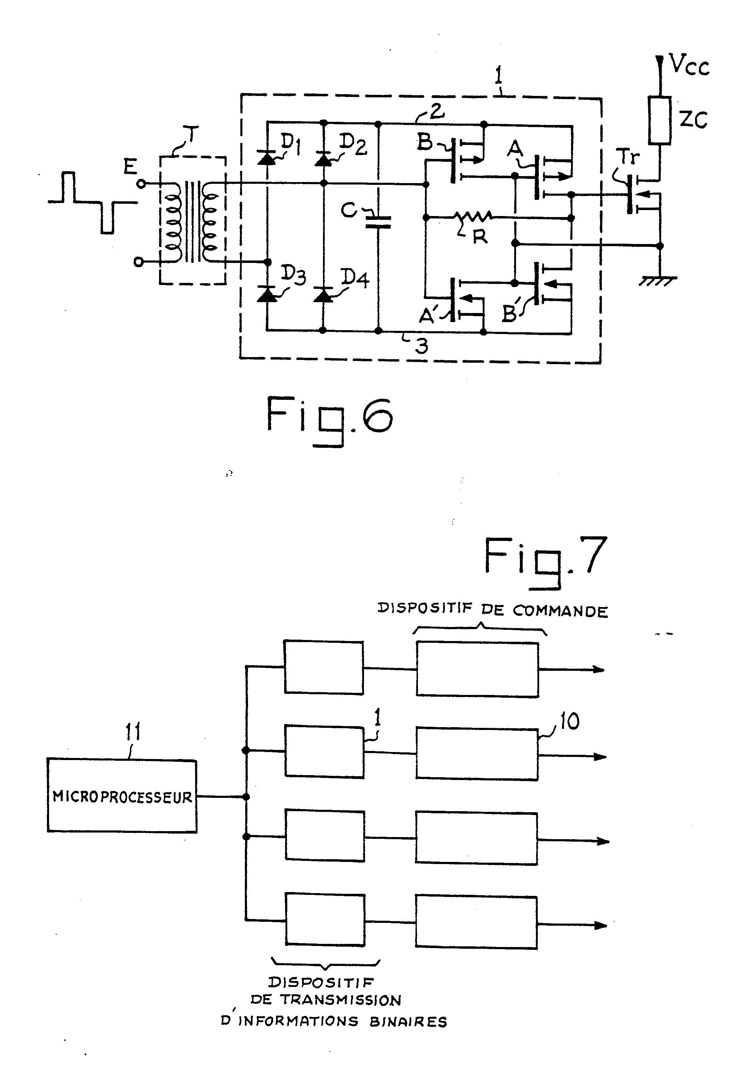

On suppose que, préalablement à la réception d'une impulsion incidente, le condensateur C est chargé, ce qui a été assuré par l'envoi préalable d'une ou plusieurs impulsions destinées à assurer ce stockage préalable d'énergie. Suivant le type - (positif ou négatif) de cette impulsion, deux des commutateurs A, A', B et B' s'ouvrent, et les deux autres se ferment, assurant ainsi le transfert de l'information présente dans cette impulsion vers la sortie du dispositif. Au même instant, la décharge brutale du condensateur C permet de superposer à cette information une grande quantité d'energie, permettant ainsi d'une part de disposer instantanément d'une grande quantité d'énergie, ce qui est très intéressant dans certaines appli cations telles que la commande de transistors MOS, $(T_r)$ telle que représentée sur la figure 6, d'autre part, par le rebouclage des commutateurs et du condensateur C, de réaliser de façon simple une mémorisation de l'information contenue dans l'impulsion incidente. Ceci permet (comme cela apparaît sur la figure 5) de reconstituer un état logique à partir d'une impulsion d'entrée extrêmement étroite, et est très intéressant, comme on l'a vu précédemment, dans l'application très générale à la transmission d'informations sur une ligne isolée galvaniquement. Suivant la durée de cet état logique et suivant la vitesse de décharge du condensateur C, il peut être nécessaire, comme cela apparaît également sur la figure 5, de renouveler l'impulsion d'entrée, de façon à entretenir le stockage d'énergie et la mémorisation de l'information contenue dans l'impulsion incidente.

Il apparaît ainsi que les différents éléments de ce dispositif assurent les fonctions suivantes :

-stockage d'énergie préalablement à la réception d'une impulsion, dans le condensateur C ;

détection d'une impulsion incidente, grâce à la commande des commutateurs A, A', B, B' par le signal en impulsions lui-même ;

-transmission de l'information contenue dans l'impulsion incidente, avec comme support l'énergie restituée par le condensateur C, à travers les deux commutateurs rendus passants ;

-mémorisation de l'information contenue dans l'impulsion incidente, grâce au rebouclage, l'un sur l'autre et à travers le condensateur C, des deux commutateurs rendus passants.

Ce dispositif reçoit donc des impulsions brèves de forte énergie, soit à chaque transition du signal à transmettre, soit périodiquement pour régénérer le signal. Si le signal à transmettre ne se présente pas directement sous la forme requise, une transformation préalable est nécessaire, qui peut être effectuée par exemple par microprocesseur. Ce signal est ensuite reconstitué, à partir de ces impulsions, par le dispositif suivant l'invention.

Un tel exemple de transformation par microprocesseur est montré sur la figure 7 qui est une application du dispositif suivant l'invention à la transmission multivoies isolées. Cette figure représente en effet un certain nombre de dispositifs de commande (10), quatre en l'occurrence, commandés respectivement par les signaux fournis par quatre dispositifs 1 suivant l'invention, eux-mêmes pilotés par un microprocesseur 11.

Le dispositif suivant l'invention est en outre adapté à de fortes charges capacitives. En effet il permet de restituer l'énergie sur les transitions du signal.

Les applications en sont multiples :

-transmission sur ligne capacitive ;

-commande d'un transistor MOS de puissance ayant une grande immunité aux bruits, les impulsions positives par exemple saturant le transistor, les impulsions négatives le bloquant ;

-transmission multivoies isolées.

## Revendications

1. Dispositif miniaturisé de transmission d'informations binaires par transformateur d'impulsions - (T) avec reconstitution de la composante continue, caractérisé en ce qu'il comporte, disposés en aval du transformateur d'impulsions (T) :

des premiers moyens (A, A', B, B') de détection d'impulsion incidente (E) ;

des deuxièmes moyens pour mémoriser l'information contenue dans cette impulsion incidente ;

des troisièmes moyens (C) pour stocker de l'énergie, préalablement à la réception de cette impulsion et pour la restituer à la détection de cette impulsion, le signal de sortie (S) étant obtenu par superposition, à cette énergie restituée, de l'information mémorisée.

2. Dispositif selon la revendication 1, caractérisé en ce qu'il comporte en outre des cinquièmes moyens pour entretenir le stockage d'énergie et la mémorisation d'information respectivement dans les troisièmes et deuxièmes moyens, avant réception d'une nouvelle impulsion incidente.

3. Dispositif selon l'une des revendications 1 et 2, caractérisé en ce que les moyens de détection d'impulsion incidente comportent deux couples de commutateurs (A, A' et B, B') commandés et alimentés par le signal incident.

4. Dispositif selon l'une des revendications 1 et 2, caractérisé en ce que les moyens de stockage d'energie comportent un condensateur (C) alimenté par le signal incident.

5. Dispositif selon l'une des revendications 1 et 2, caractérisé en ce que les moyens de mémorisation d'information contenue dans l'impulsion incidente consistent dans le rebouclage des commutateurs (A, A' ou B, B') à travers les moyens de stockage d'énergie (C).

Fig.1

Fig.2

Fig.3

Fig.5

Fig.4

Fig.6

Fig.7

DISPOSITIF DE COMMANDE

MICROPROCESSEUR

DISPOSITIF
DE TRANSMISSION
D'INFORMATIONS BINAIRES

Office européen
des brevets

**RAPPORT DE RECHERCHE EUROPEENNE**

Numero de la demande

EP 86 40 1260

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl.4) |
|---|---|---|---|
| X | DE-A-3 226 998 (EBERHARD BAUER ELEKTROMOTOREN FABRIK GmbH) * Figures 1,5; page 17, ligne 1 - page 22, ligne 3; page 26, lignes 11-26; page 30, dernier alinéa - page 33, ligne 3 * | 1-5 | H 03 K 17/687 H 03 K 3/356 |
| | --- | | |
| X | DE-A-3 243 660 (PICHLER et al.) * Figures 1,3; page 5, ligne 13 - page 12, ligne 16 * | 1,4 | |
| | --- | | |
| A | US-A-4 124 807 (HERBER) * Figures 1,2; colonne 1, ligne 59 - colonne 4, ligne 51 * | 1,3,5 | |
| | ----- | | |

DOMAINES TECHNIQUES
RECHERCHES (Int. Cl.4)

H 03 K

Le présent rapport de recherche a été établi pour toutes les revendications

| Lieu de la recherche | Date d'achèvement de la recherche | Examinateur |
|---|---|---|
| LA HAYE | 18-09-1986 | FEUER F.S. |